(19) Europäisches Patentamt
European Patent Office
Office européen des brevets

(11)     **EP 3 618 325 B1**

(12)                    **EUROPEAN PATENT SPECIFICATION**

(45) Date of publication and mention
of the grant of the patent:
**01.12.2021 Bulletin 2021/48**

(51) Int Cl.:
*H04L 27/00* $^{(2006.01)}$  *H04W 52/26* $^{(2009.01)}$
*H04L 1/00* $^{(2006.01)}$  *H03K 23/00* $^{(2006.01)}$
*H04L 27/34* $^{(2006.01)}$

(21) Application number: **18803129.8**

(22) Date of filing: **18.04.2018**

(86) International application number:
**PCT/CN2018/083607**

(87) International publication number:
**WO 2018/210095 (22.11.2018 Gazette 2018/47)**

(54) **POWER CONTROL METHOD AND DEVICE**

LEISTUNGSSTEUERUNGSVERFAHREN UND -VORRICHTUNG

PROCÉDÉ ET DISPOSITIF DE RÉGULATION DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.05.2017 CN 201710359004**

(43) Date of publication of application:
**04.03.2020 Bulletin 2020/10**

(73) Proprietor: **Huawei Technologies Co., Ltd.
Longgang District
Shenzhen, Guangdong 518129 (CN)**

(72) Inventors:
• **ZHOU, Zhengyang
Shenzhen
Guangdong 518129 (CN)**
• **LIANG, Wei
Shenzhen
Guangdong 518129 (CN)**
• **WANG, Yifan
Shenzhen
Guangdong 518129 (CN)**

(74) Representative: **Gill Jennings & Every LLP
The Broadgate Tower
20 Primrose Street
London EC2A 2ES (GB)**

(56) References cited:
**WO-A1-2016/127747    WO-A1-2016/144100
CN-A- 103 281 111    CN-A- 105 634 654
CN-A- 106 411 801**

• **NOKIA ALCATEL-LUCENT SHANGHAI BELL:
"On remaining details of MUST Case 1 and 2",
3GPP DRAFT; R1-1612791 ON THE REMAINING
DETAILS OF MUST CASE 1 AND 2, 3RD
GENERATION PARTNERSHIP PROJECT (3GPP),
MOBILE COMPETENCE CENTRE ; 650, ROUTE
DES LUCIOLES ; F-06921 SOPHIA-ANTIPOLIS
CEDEX ; F , vol. RAN WG1, no. Reno, U.S.A.;
20161114 - 20161118 13 November 2016
(2016-11-13), XP051176733, Retrieved from the
Internet:
URL:http://www.3gpp.org/ftp/Meetings_3GPP_
SYNC/RAN1/Docs/ [retrieved on 2016-11-13]**

## Description

### TECHNICAL FIELD

Embodiments of the present application relate to the field of communications technologies, and in particular, to a power control method and a device.

### BACKGROUND

Currently, a data transmission processing procedure of a physical downlink shared channel (PDSCH) is as follows: After a cyclic redundancy check (CRC) is performed on data to complete verification code addition, encoding, and rate matching, scrambling is performed to obtain a scrambled bit stream; and then, after modulation, power control, and layer mapping are performed on the scrambled bit stream, the scrambled bit stream is sent through an antenna.
If two terminal devices need to perform code division multiplexing, scrambled bit streams corresponding to the two terminal devices needs to be combined, and subsequent operations such as modulation, power control, and layer mapping are uniformly performed on a bit stream obtained after the combination. Uniformly performing the power control is to use one power control factor for control. It can be learned that code division multiplexing of terminal devices is implemented in the foregoing process. However, flexibility of the power control is lost because the two terminal devices share one power control factor.
WO 2016/144100 A1 discloses a method for transmitting and receiving a signal in a wireless communication system.

### SUMMARY

Embodiments of the present application provide a power control method and a device, to improve flexibility of power control.
According to a first aspect, a method is provided, and the method may be applied to a communications device. In the method, a base station modulates a first bit stream by using a first modulation scheme, to obtain a first modulation symbol, modulates a second bit stream by using a second modulation scheme, to obtain a second modulation symbol, and modulates, by using a third modulation scheme, a combined bit stream obtained by combining the first bit stream and the second bit stream, to obtain a joint modulation symbol; obtains a first modification coefficient and a second modification coefficient based on the first modulation symbol, the second modulation symbol, and the joint modulation symbol; modifies the first modulation symbol by using the first modification coefficient, to obtain a first modified modulation symbol, and modifies the second modulation symbol by using the second modification coefficient, to obtain a second modified modulation symbol; performs power control processing on the first modified modulation symbol by using a preset first power control factor, to obtain a first modified modulation symbol obtained after the power control, and performs power control processing on the second modified modulation symbol by using a preset second power control factor, to obtain a second modified modulation symbol obtained after the power control; and combines the first modified modulation symbol obtained after the power control and the second modified modulation symbol obtained after the power control, and sends to a terminal device, a combined modulation symbol obtained after the power control.
In this embodiment of the present application, the base station separately modulates the first bit stream and the second bit stream. To be specific, the base station separately performs power allocation on terminal devices such as a first terminal device and a second terminal device, to ensure that independent power allocation is performed on different terminal devices while code division multiplexing is implemented, thereby improving flexibility of power control and improving signal quality of the terminal device.
In a possible design, the obtaining, by the base station, a first modification coefficient and a second modification coefficient based on the first modulation symbol, the second modulation symbol, and the joint modulation symbol includes: obtaining, by the base station, the first modification coefficient and the second modification coefficient based on an equivalent relationship between the joint modulation symbol and a combined modulation symbol that is obtained by combining a result obtained by multiplying the first modulation symbol by the first modification coefficient and a result obtained by multiplying the second modulation symbol by the second modification coefficient.
In this embodiment of the present application, representations of the first modification coefficient and the second modification coefficient are related to modulation types of the first modulation scheme and the second modulation scheme. The first modification coefficient and the first modulation scheme are used as an example. For example, when the first modulation scheme is quadrature phase shift keying (QPSK), the first modification coefficient is represented as a modification factor $k_a$; when the first modulation scheme is quadrature amplitude modulation (QAM), the first modification coefficient is represented as modulation factors $k_{a0}$ and $k_{a1}$.
In a possible design, the obtaining, by the base station, the first modification coefficient and the second modification coefficient based on an equivalent relationship between the joint modulation symbol and a combined modulation symbol includes: obtaining, by the base station, a real part of the combined modulation symbol and a real part of the joint modulation symbol; and obtaining, by the base station, a value of the first modification coefficient and a value of the second modification coefficient based on a numerical relationship between the real part of the combined modulation symbol and the real part of the joint modulation symbol; or the obtaining, by the base station, the first modification coefficient and the second modification coefficient based on an equivalent relationship between the joint modulation symbol and the combined modulation symbol includes: obtaining, by the base station, an imaginary part of the combined modulation symbol and an imaginary part of the joint modulation symbol; and obtaining, by the base station, the first modification coefficient and the second modification coefficient based on a numerical relationship between the imaginary part of the combined modulation symbol and the imaginary part of the joint modulation symbol.

In this embodiment of the present application, because a modulation constellation diagram is a centro symmetric constellation diagram, a real part and an imaginary part of a corresponding modulation symbol are the same. Therefore, the first modification coefficient and the second modification coefficient are obtained by using the numerical relationship between the real part of the combined modulation symbol and the real part of the joint modulation symbol, thereby reducing calculation complexity.

In this embodiment of the present application, the first modification coefficient and the second modification coefficient may also be obtained based on the numerical relationship between the imaginary part of the combined modulation symbol and the imaginary part of the joint modulation symbol. This is not limited in this embodiment of the present application.

In a possible design, a modulation constellation diagram corresponding to the third modulation scheme is a Gray code modulation constellation diagram; before the modulating, by the base station, a second bit stream by using a second modulation scheme, to obtain a second modulation symbol, the method further includes: performing, by the base station, an XNOR operation on the first bit stream and the second bit stream, to obtain a third bit stream; and the modulating, by the base station, a second bit stream by using a second modulation scheme, to obtain a second modulation symbol includes: modulating, by the base station, the third bit stream by using the second modulation scheme, to obtain the second modulation symbol.

In this embodiment of the present application, when the modulation constellation diagram corresponding to the third modulation scheme is the Gray code modulation constellation diagram, a modulation process is for Gray code binary, and an expansion formula of a modulation function corresponding to a modulation scheme is for natural binary. Therefore, to apply to the expansion formula of the modulation function, the base station needs to convert the combined bit stream from the Gray code binary to the natural binary. For this purpose, before modulating the second bit stream, the base station performs the XNOR operation on the first bit stream and the second bit stream, and then modulates the third bit stream by using the second modulation scheme.

In a possible design, the performing, by the base station, power control processing on the first modified modulation symbol by using a preset first power control factor, to obtain a first modified modulation symbol obtained after the power control, and performing power control processing on the second modified modulation symbol by using a preset second power control factor, to obtain a second modified modulation symbol obtained after the power control includes: multiplying, by the base station, the first modified modulation symbol by the first power control factor, to obtain the first modified modulation symbol obtained after the power control, and multiplying the second modified modulation symbol by the second power control factor, to obtain the second modified modulation symbol obtained after the power control.

In this embodiment of the present application, the first power control factor and the second power control factor may be determined by using a downlink power allocation method in the prior art, for example, improving a transmit power of a reference signal or using a related mechanism for implementing inter-cell interference suppression in combination with user scheduling, or by using another power allocation method. This is not limited in this embodiment of the present application.

In a possible design, the first modulation scheme is a quadrature phase shift keying QPSK modulation scheme, and the second modulation scheme is a 16QAM quadrature amplitude modulation scheme or a QPSK modulation scheme; or the first modulation scheme is a 16QAM modulation scheme, and the second modulation scheme is a QPSK modulation scheme.

Several forms of the first modulation scheme and the second modulation scheme are provided. Forms of the first modulation scheme and the second modulation scheme are not limited to the foregoing several enumerated forms in this embodiment of the present application.

According to a second aspect, a communications device is provided. The communications device includes a modulation module, an obtaining module, a modification module, a power control module, and a combination and sending module, and modules included in the communications device are configured to perform the power control method in the first aspect.

According to a third aspect, a communications device is provided. In a possible design, a structure of the communications device includes a processor and a transmitter. The processor is configured to support the communications device in performing a corresponding function in the power control method in the first aspect. The transmitter is configured to send a combined modulation symbol obtained after power control through combining performed by the processor. The communications device may further include a memory. The memory is coupled to the processor, and is configured to store a program instruction and data that are required for the communications device.

According to a fifth aspect, a computer program product is provided. The computer program product includes an instruction. When the instruction runs on a computer, the computer performs the method in the foregoing aspects.

In the power control solution provided in the embodiments of the present application, the base station separately modulates the first bit stream and the second bit stream. To be specific, the base station separately performs power allocation on terminal devices such as a first terminal device and a second terminal device, to ensure that independent power allocation is performed on different terminal devices while the code division multiplexing is implemented, thereby improving the flexibility of the power control and improving the signal quality of the terminal device.

## BRIEF DESCRIPTION OF DRAWINGS

FIG. 1 is a systematic architectural diagram of an EPS;
FIG. 2 is a schematic flowchart of data processing of a terminal device in a physical downlink shared channel;
FIG. 3 is a schematic flowchart of data processing of a terminal device for code division multiplexing of a physical downlink shared channel;
FIG. 4 is a flowchart of a power control method according to an embodiment of the present application;
FIG. 5 is a QPSK modulation constellation diagram according to an embodiment of the present application;
FIG. 6 is a schematic diagram of a power control method when a modulation constellation diagram is a Gray code constellation diagram according to an embodiment of the present application;
FIG. 7 is a schematic structural diagram of a communications device according to an embodiment of the present application; and
FIG. 8 is a schematic structural diagram of a communications device according to an embodiment of the present application.

## DESCRIPTION OF EMBODIMENTS

To make the purpose, technical solutions, and advantages of the embodiments of the present application clearer, the following clearly describes the technical solutions of the embodiments of the present application with reference to the accompanying drawings in the embodiments of the present application.

In the following, some terms in the embodiments of the present application are described, so as to help persons skilled in the art have a better understanding.

(1) A network device includes, for example, a base station (for example, an access point), and may be a device that communicates in an access network with a wireless terminal device by using one or more sectors over an air interface. The base station may be configured to mutually convert a received over-the-air frame and an IP packet and serve as a router between user equipment and a rest portion of the access network, where the rest portion of the access network may include an IP network. The base station may further coordinate attribute management of the air interface. For example, the base station may include an evolved NodeB (NodeB, eNB, or e-NodeB) in a Long Term Evolution (LTE) system or an LTE-advanced system (LTE-A), or may include a next generation nodeB (NG-NB) in a 5th generation (5G) system. This is not limited in the embodiments of the present application.

(2) A terminal device includes a device that provides a user with voice and/or data connectivity, for example, may include a handheld device with a wireless connection function, or a processing device connected to a wireless modem. The terminal device may communicate with a core network by using a radio access network (RAN), and exchange voice and/or data with the RAN. The terminal device may include user equipment (UE), a wireless terminal device, a mobile terminal device, a subscriber unit, a subscriber station, a mobile station, a remote station, an access point (AP), a remote terminal device, an access terminal device, a user terminal device, a user agent, a user device, or the like. For example, the terminal device may include a mobile phone (or referred to as a "cellular" phone), a computer with a mobile terminal device, a portable, pocket-sized, handheld, computer built-in, or in-vehicle mobile apparatus, or an intelligent wearable device. For example, the terminal device may be a device such as a personal communications service (PCS) phone, a cordless telephone set, a Session Initiation Protocol (SIP) phone, a wireless local loop (WLL) station, a personal digital assistant (PDA), a smartwatch, a smart helmet, smart glasses, or a smart band. The terminal device further includes a limited device, for example, a device with relatively low power consumption, a device with a limited storage capability, or a device with a limited computing capability. For example, the terminal device includes an information sensing device such as a barcode, radio frequency identification (RFID), a sensor, a global positioning system (GPS), or a laser scanner.

(3) In addition, the term "and/or" in this specification describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects unless specified otherwise. In the description of the embodiments of the present application, terms such as "first" and "second" are only used for distinction and description, but cannot be understood as indication or implication of relative importance, and cannot be understood as an indication or implication of a sequence.

An application scenario of an embodiment of the present application is first briefly described.

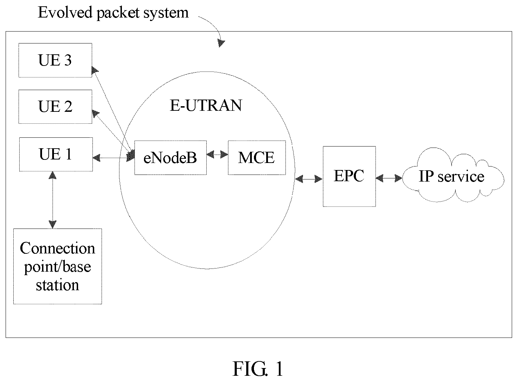

FIG. 1 schematically shows a wireless communications system applicable to the technical solutions provided in embodiments of the present application. The wireless communications system may be an evolved packet system (EPS) or another type of system.

The EPS may include one or more user equipments (UE 1, UE 2, UE 3, and the like), an evolved universal terrestrial radio access network (Evolved Universal Terrestrial Radio Access Network, E-UTRAN), an evolved packet core (Evolved Packet Core, EPC), and an Internet Protocol (Internet Protocol, IP) service between carrier networks. In addition, the EPS can also be connected to another access network (not shown in the figure).

The E-UTRAN may include one or more eNodeBs, and may further include a multicast coordination entity (MCE). When the E-UTRAN includes a plurality of eNodeBs, one eNodeB may be connected to another eNodeB through backhaul. The MCE may allocate a time-frequency radio resource to an evolved multimedia broadcast/multicast service (eMBMS), and determine a radio configuration for the eMBMS. The MCE may be an entity independent of the eNodeB, or may be a part of the eNodeB.

UE may communicate with the eNodeB by using a Long Term Evolution (LTE) link (including an LTE downlink and an LTE uplink). In addition, the UE may also communicate with another connection point (CP) by using a millimeter wave (mmW) link.

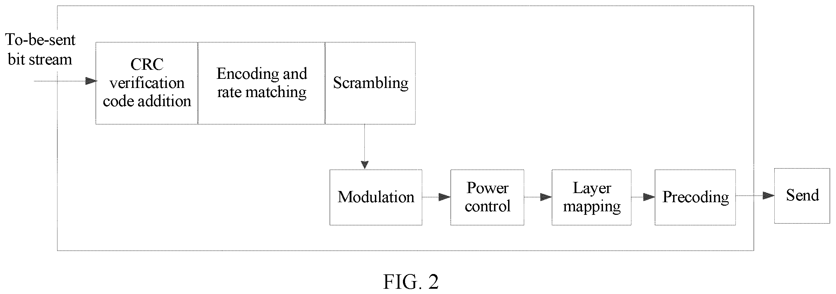

FIG. 2 schematically shows a data processing procedure of a physical downlink shared channel (PDSCH) in a wireless communications system shown in FIG. 1. For data to be sent to a terminal device, cyclic redundancy check (CRC) verification code addition, encoding, and rate matching need to be performed; then, scrambling is performed to obtain a scrambled bit stream; next, modulation, power control, and layer mapping are performed on the scrambled bit stream; and finally, the scrambled bit stream is sent through an antenna.

The power control in the foregoing processing procedure is mainly to allocate power to each terminal device. A meaning of downlink power control is as follows:

1. In a wireless channel environment, it cannot be ensured that all cells have a same downlink transmit power, due to a requirement of network deployment, different geographical locations, and the like. A relatively large cell power causes interference to a neighboring cell. However, a relatively small power cannot cover an entire cell, thereby causing relatively poor signal quality at a cell edge. Therefore, inter-cell interference suppression is closely related to proper power allocation.

2. Power of each downlink channel or a power relationship between a data signal and a reference signal (RS) cannot be unchanged. For example, for the reference signal, because channel estimation needs to be performed, power of the reference signal is higher than that of the data signal, to ensure correct demodulation and decoding of the reference signal. In addition, how a downlink control channel can correctly receive the data signal is also closely related to proper power allocation.

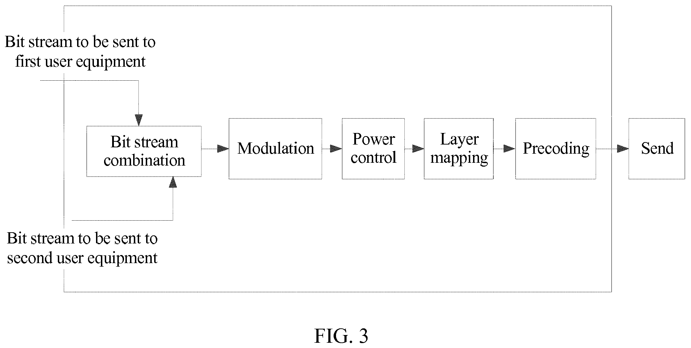

Further, in a base station of the wireless communications system, data of a plurality of terminal devices is usually multiplexed on one frequency resource, to improve a system throughput. FIG. 3 schematically shows a PDSCH data processing procedure when two terminal devices need to perform code division multiplexing in the prior art.

When the two terminal devices need to perform the code division multiplexing, CRC verification code addition, encoding, rate matching, and scrambling are separately performed on a first bit stream and a second bit stream, to obtain two bit streams; the two bit streams are combined for modulation, to obtain a joint modulation symbol; and power control and layer mapping are performed on the joint modulation symbol, and then the joint modulation symbol is allocated to an antenna for sending.

However, for the PDSCH data processing procedure shown in FIG. 3, when an advantage of the code division multiplexing is obtained, the first bit stream and the second bit stream are combined for modulation, to obtain the joint modulation symbol, and then the power control is uniformly performed on the joint modulation symbol. In other words, the power control is performed on the joint modulation symbol by using one power control factor. Consequently, a first terminal device and a second terminal device share one power control factor, losing flexibility of the power control.

In view of this, an embodiment of the present application provides a power control method. In the power control method, the base station separately modulates the first bit stream and the second bit stream. To be specific, the base station performs independent power allocation on terminal devices such as the first terminal device and the second terminal device, to ensure that independent power allocation is performed on different terminal devices while the code division multiplexing is implemented, thereby improving the flexibility of the power control and improving signal quality of the terminal device.

The following describes the technical solutions in the embodiments of the present application in detail with reference to the accompanying drawings in this specification and specific embodiments. The following description process uses an example in which the technical solutions provided in the embodiments of the present application are applied to the application scenario shown in FIG. 1, and an example in which a terminal device included in the application scenario includes first user equipment and second user equipment.

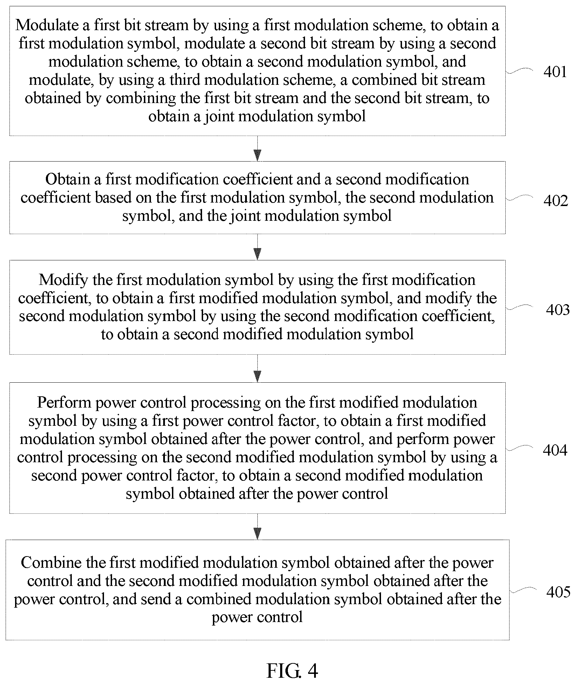

Referring to FIG. 4, an embodiment of the present application provides a power control method. A procedure of the method is described as follows:

Step 401: A base station modulates a first bit stream by using a first modulation scheme, to obtain a first modulation symbol, modulates a second bit stream by using a second modulation scheme, to obtain a second modulation symbol, and modulates, by using a third modulation scheme, a combined bit stream obtained by combining the first bit stream and the second bit stream, to obtain a joint modulation symbol, where the third modulation scheme is obtained based on the first modulation scheme and the second modulation scheme.

In this embodiment of the present application, first user equipment and second user equipment are code division multiplexing devices, and it indicates that the first bit stream and the second bit stream are multiplexed into a same frequency sub-band.

In this embodiment of the present application, before step 401 is performed, the base station may schedule a plurality of user equipments for each frequency sub-band. To be specific, the base station determines to multiplex data to be sent to specific user equipments into the frequency sub-band. For example, the base station may schedule each user equipment based on channel state information (CSI) fed back by each user equipment, for example, a channel quality indicator (CQI).

If the base station determines to multiplex the first bit stream and the second bit stream into the same frequency sub-band, the base station adds a CRC verification code to the first bit stream, and encodes the bit stream with the added verification code. For example, the base station uses an encoding method well-known in the art based on a modulation and coding scheme (MCS) allocated to each user equipment, to encode a bit stream to be sent to the user equipment, thereby generating an encoded signal. Rate matching and scrambling are performed on the encoded signal, to obtain a scrambled first bit stream that is denoted as A: $\{a_0, a_1, ...\}$, for example, {1, (, ...} or {0, 1, ...}.

A manner of processing the second bit stream by the base station is similar to a manner of processing the first bit stream, and details are not described herein again. A scrambled second bit stream obtained by the base station is denoted as B: $\{b_0, b_1, b_2, b_3...\}$, for example, {0, 1, 1, 0, ...} or {0, 0, 0,1, ...}.

The first modulation scheme and the second modulation scheme in this embodiment of the present application may be a same modulation scheme. For example, the first modulation scheme is quadrature phase shift keying (QPSK), and the second modulation scheme is QPSK modulation. The first modulation scheme and the second modulation scheme may alternatively be different modulation schemes. For example, the first modulation scheme is QPSK modulation, and the second modulation scheme is hexadecimal quadrature amplitude modulation (QAM); or the first modulation scheme is 16QAM modulation, and the second modulation scheme is QPSK modulation.

In this embodiment of the present application, the third modulation scheme is obtained based on the first modulation scheme and the second modulation scheme. In a specific implementation process, the first modulation scheme is QPSK modulation, the second modulation scheme is QPSK modulation, and the third modulation scheme is 16QAM modulation; or the first modulation scheme is QPSK modulation, the second modulation scheme is 16QAM modulation, and the third modulation scheme is 64QAM modulation; or the first modulation scheme is 16QAM modulation, the second modulation scheme is QPSK modulation, and the third modulation scheme is 64QAM modulation; or there may be another case. This is not limited in this embodiment of the present application.

If the first modulation scheme and/or the second modulation scheme correspond/corresponds to QPSK, a quantity of bits that are used to encode a signal and that are of a symbol corresponding to each constellation point in a constellation diagram of a modulation symbol is 2. The points in the constellation diagram have a same amplitude but different phases. If the first modulation scheme and/or the second modulation scheme correspond/corresponds 16QAM, a quantity of bits that are used to encode a signal and that are of a symbol corresponding to each constellation point in a constellation diagram of a modulation symbol is 4, and a point in the constellation diagram is no longer located in a unit circle, but is distributed within a specific range of a complex plane. If points in the constellation diagram have a same amplitude, the points do not need to have a same phase; or if points in the constellation diagram have a same phase, the points do not need to have a same amplitude. If the first modulation scheme and/or the second modulation scheme correspond/corresponds 64QAM, a quantity of bits that are used to encode a signal and that are of a symbol corresponding to each constellation point in a constellation diagram of a modulation symbol is 6.

In this embodiment of the present application, the base station may map, in a plurality of manners, a bit to the symbol corresponding to the constellation point in the constellation diagram. For example, the base station may map the bit to the symbol corresponding to each constellation point in the constellation diagram based on a mapping table of a mapping relationship between the bit and the symbol corresponding to each constellation point in the constellation diagram, and the mapping table may be predefined and stored in the base station and each user equipment. Alternatively, the base station may directly map the bit to the symbol corresponding to each constellation point in the constellation diagram based on a mapping manner known to both the base station and each user equipment. In this way, the mapping table in the previous mapping manner may not need to be set. This is relatively simple. Alternatively, mapping may be performed in another mapping manner. This is not limited in this embodiment of the present application.

In this embodiment of the present application, when needing to obtain the joint modulation symbol, the base station needs to combine the first bit stream and the second bit stream. If a quantity of bits of the first bit stream is the same as a quantity of bits of the second bit stream, the first bit stream and the second bit stream are sequentially combined at an equal interval. For example, the first bit stream is $\{a_0, a_1, ...\}$, the second bit stream is $\{b_0, b_1, ...\}$, $a_0$ of the first bit stream is used as a first bit of the combined bit stream, and the obtained combined bit stream is $\{a_0, b_0, a_1, b_1...\}$. If a quantity of bits of the first bit stream is different from a quantity of bits of the second bit stream, an interval, in the combined bit stream, of adjacent bits in the second bit stream is determined based on the quantity of bits of the first bit stream and the quantity of bits of the second bit stream, and then the first bit stream and the second bit stream are combined based on the interval. For example, the first bit stream is $\{a_0, a_1, \cdots\}$, and the second bit stream is $\{b_0, b_1, b_2, b_3, ...\}$. If a first bit $a_0$ of the first bit stream $\{a_0, a_1, ...\}$ is used as a first bit of the combined bit stream, the obtained combined bit stream is $\{a_0, b_0, b_1, a_1, b_2, b_3\}$. If a first bit $b_0$ of the second bit stream $\{b_0, b_1, b_2, b_3, ...\}$ is used as a first bit of the combined bit stream, the obtained combined bit stream is $\{b_0, b_2, a_0, b_1, b_3, a_1\}$. This may be selected according to an actual situation.

Step 402: The base station obtains a first modification coefficient and a second modification coefficient based on the first modulation symbol, the second modulation symbol, and the joint modulation symbol.

In a specific implementation process, a location of the constellation point in the constellation diagram is related to power allocated to each user equipment. Therefore, as the power allocated to each user equipment changes, the constellation diagram may be a regular constellation diagram, or may be an irregular constellation diagram. In the regular constellation diagram, constellation points are evenly distributed, while in the irregular constellation diagram, constellation points are unevenly distributed. For example, when two bit streams are multiplexed in the frequency sub-band, and both the first modulation scheme and the second modulation scheme are QPSK modulation, if a ratio of a power $P_1$ allocated to the first user equipment to a power $P_2$ allocated to the second user equipment is 0.8:0.2, a constellation diagram corresponding to the third modulation scheme used to modulate the combined bit stream is the same as a 16QAM constellation diagram and is a regular constellation diagram. However, if a ratio of a power $P_1$ allocated to the first user equipment to a power $P_2$ allocated to the second user equipment is another value, a joint modulation constellation diagram is different from a 16QAM constellation diagram and is an irregular constellation diagram.

In this embodiment of the present application, if both the power allocated to the first user equipment and the power allocated to the second user equipment are $P$, the first modulation symbol and the second modulation symbol need to be modified, to ensure that a result of separately modulating the first bit stream and the second bit stream by the base station is the same as a result of jointly modulating the first bit stream and the second bit stream.

Specifically, in this embodiment of the present application, the base station obtains the first modification coefficient and the second modification coefficient based on an equivalent relationship between the joint modulation symbol and a combined modulation symbol that is obtained by combining a result obtained by multiplying the first modulation symbol by the first modification coefficient and a result obtained by multiplying the second modulation symbol by the second modification coefficient.

In this embodiment of the present application, an example in which the first modulation scheme is QPSK modulation, the second modulation scheme is QPSK modulation, and the third modulation scheme is 16QAM modulation is used to describe obtaining of the first modification coefficient and the second modification coefficient.

If the first bit stream is A: $\{a_0, a_1\}$, and the second bit stream is B: $\{b_0, b_1\}$, the base station modulates the first bit stream by using the QPSK modulation scheme, to obtain the first modulation symbol $F_{QPSK}(a_0, a_1)$, and modulates the second bit stream by using the QPSK modulation scheme, to obtain the second modulation symbol $F_{QPSK}(b_0, b_1)$. The result obtained by multiplying the first modulation symbol by the first modification coefficient $k_a$ is $k_a * F_{QPSK}(a_0, a_1)$, the result obtained by multiplying the second modulation symbol by the second modification coefficient $k_b$ is $k_b * F_{QPSK}(b_0, b_1)$, and the combined modulation symbol that is obtained by combining the result obtained by multiplying the first modulation symbol by the first modification coefficient and the result obtained by multiplying the second modulation symbol by the second modification coefficient is $k_a * F_{QPSK}\{a_0, a_1\} + k_b * F_{QPSK}\{b_0, b_1\}$.

The base station combines the first bit stream and the second bit stream to obtain the combined bit stream $(a_0, b_0, a_1, b_1)$, modulates the combined bit stream by using a 16QAM modulation scheme, to obtain the joint modulation

symbol $F_{16QAM}$ ($a_0$, $b_0$, $a_1$, $b_1$), and obtains formula (1) based on the equivalent relationship between the joint modulation symbol and the combined modulation symbol.

$$P * F_{16QAM}\left(a_0, \ b_0, \ a_1, \ b_1\right) = k_a * P * F_{QPSK}\left(a_0, \ a_1\right) + k_b * P * F_{QPSK}\left(b_0, \ b_1\right) \quad (1)$$

For a binary centrosymmetric constellation pattern, modulation functions $F_{QPSK}$ and $F_{16QAM}$ can be respectively expanded to the following formulas:

$$F_{QPSK}\left(x_0, \ x_1\right) = \left\{q_0^{QPSK} * x_0, \ q_0^{QPSK} * x_1\right\} \quad (2)$$

$$F_{16QAM}\left(y_0, \ y_1, \ y_2, \ y_3\right) = \left\{q_1^{16QAM} * y_0 + q_0^{16QAM} * y_1, \ q_1^{16QAM} * y_2 + q_0^{16QAM} * y_3\right\} \quad (3)$$

In formula (2), $q_0^{QPSK}$ is a coefficient obtained by expanding a binomial for coordinates of a QPSK binary constellation diagram, for example, $1/\sqrt{2}$. In formula (3), $q_1^{16QAM}$ and $q_0^{16QAM}$ are coefficients obtained by expanding a binomial for coordinates of a 16QAM binary constellation diagram, and $q_1^{16QAM}$ and $q_0^{16QAM}$ are obtained through calculation based on the coordinates of the 16QAM binary constellation diagram, for example, $q_1^{16QAM} = 2/\sqrt{10}$ and $q_0^{16QAM} = 1/\sqrt{10}$.

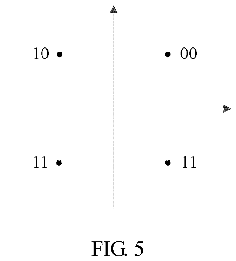

In formula (2), $x_0$, $x_1$ on a left side of the equation represents the first bit stream or the second bit stream. In formula (3), $y_0$, $y_1$, $y_2$, $y_3$ on a left side of the equation represents the combined bit stream of the first bit stream and the second bit stream. However, on a right side of the equation in formula (2) and formula (3), $x_0$, $x_1$ and $y_0$, $y_1$, $y_2$, $y_3$ represent a symbol item. Specifically, referring to FIG. 5, a QPSK modulation constellation diagram is used as an example. A constellation point corresponding to bits 00 corresponds to a $\dfrac{\pi}{4}$ phase, and both horizontal and vertical coordinates are positive. A constellation point corresponding to bits 10 corresponds to a $\dfrac{3\pi}{4}$ phase, a horizontal coordinate is negative, and a vertical coordinate is positive. A constellation point corresponding to bits 11 corresponds to a $\dfrac{5\pi}{4}$ phase, and both horizontal and vertical coordinates are negative. A constellation point corresponding to bits 01 corresponds to a $\dfrac{7\pi}{4}$ phase, a horizontal coordinate is positive, and a vertical coordinate is negative. Therefore, it can be learned that if $x$ is 0, on the right side of formula (2) and formula (3), $x$ represents +1; or if $x$ is 1, on the right side of formula (2) and formula (3), $x$ represents -1.

Formula (2) and formula (3) are applied to formula (1), to obtain the following formula (4):

$$\left\{q_1^{16QAM} * a_0 + q_0^{16QAM} * b_0, \ q_1^{16QAM} * a_1 + q_0^{16QAM} * b_1\right\} = k_a\left\{q_0^{QPSK} * a_0, \ q_0^{QPSK} * a_1\right\} + k_b\left\{q_0^{QPSK} * b_0, \ q_0^{QPSK} * b_1\right\} \quad (4)$$

Further, the constellation pattern is a centrosymmetric constellation diagram, and a real part and an imaginary part of a corresponding modulation symbol are the same. Therefore, to reduce calculation complexity, the base station can obtain the first modification coefficient and the second modification coefficient by using a numerical relationship between a real part of the combined modulation symbol and a real part of the joint modulation symbol. For the centrosymmetric constellation diagram, a constellation point corresponding to the bits 00 in the constellation diagram is used as an example, and after the constellation point is rotated by 180 degrees from an origin, bitwise invert is performed on the bits 00 corresponding to the constellation point so that the bits become the same as bits corresponding to a constellation point at this location in an original constellation diagram.

Formula (5) is obtained based on an equal relationship of real parts on two sides of an equal sign in formula (4):

$$\left\{q_1^{16QAM} * a_0 + q_0^{16QAM} * b_0\right\} = \left\{k_a q_0^{QPSK} * a_0 + k_b q_0^{QPSK} * b_0\right\} \quad (5)$$

Corresponding items on two sides of formula (5) are equal, and $x_0$, $x_1$ and $y_0$, $y_1$, $y_2$, $y_3$ represent a relationship of symbol items. Therefore, the first modification coefficient $k_a = q_1^{16QAM} / q_0^{QPSK}$ and the second modification coefficient $k_b = q_0^{16QAM} / q_0^{QPSK}$ can be obtained.

In the following, an example in which the first modulation scheme is QPSK modulation, the second modulation scheme is 16QAM modulation, and the third modulation scheme is 64QAM modulation is used to describe obtaining of the first modification coefficient and the second modification coefficient. The foregoing example is still used. If the first bit stream is A: $\{a_0, a_1, ...\}$, the second bit stream is B: $\{b_0, b_1, b_2, b_3, \cdots\}$, a power control factor is P when QPSK modulation is performed on A: $\{a_0, a_1, \cdots\}$, and a power control factor is also P when 16QAM modulation is performed on B: $\{b_0, b_1, b_2, b_3, ...\}$, the base station modulates the first bit stream by using the QPSK modulation scheme, to obtain the first modulation symbol $F_{QPSK}(a_0, a_1)$, and modulates the second bit stream by using the 16QAM modulation scheme, to obtain the second modulation symbol $F_{16QAM}(b_0, b_1, b_2, b_3)$. The result obtained by multiplying the first modulation symbol by the first modification coefficient $k_a$ is $k_a * F_{QPSK}(a_0, a_1)$, the result obtained by multiplying the second modulation symbol by the second modification coefficient $k_b(k_{b0}, k_{b1})$ is $k_a * F_{16QAM}(b_0, b_1, b_2, b_3)$, and the combined modulation symbol that is obtained by combining the result obtained by multiplying the first modulation symbol by the first modification coefficient and the result obtained by multiplying the second modulation symbol by the second modification coefficient is $k_b * F_{16QAM}(b_0, b_1, b_2, b_3) + k_a * F_{QPSK}(a_0, a_1)$.

The base station combines the first bit stream and the second bit stream to obtain the combined bit stream $\{b_0, b_1, a_0, b_2, b_3, a_1\}$, modulates the combined bit stream by using a 64QAM modulation scheme, to obtain the joint modulation symbol $F_{64QAM}(b_0, b_1, a_0, b_2, b_3, \alpha_1)$, and obtains formula (6) based on the equivalent relationship between the joint modulation symbol and the combined modulation symbol.

$$P * F_{64QAM}\left(b_0, b_1, a_0, b_2, b_3, a_1\right) = k_b * P * F_{16QAM}\left(b_0, b_1, b_2, b_3\right) + k_a * P * F_{QPSK}\left(a_0, a_1\right) \quad (6)$$

For a binary centrosymmetric constellation pattern, a modulation function $F_{64QAM}$ can be expanded to the following equation:

$$F_{64QAM}\left(z_0, z_1, z_2, z_3, z_4, z_5\right) = \left\{q_2^{64QAM} * z_0 + q_1^{64QAM} * z_1 + q_0^{64QAM} * z_2, q_2^{64QAM} * z_3 + q_1^{64QAM} * z_4 + q_0^{64QAM} * z_5\right\} \quad (7)$$

Formula (2), formula (3), and formula (7) are applied to formula (6), to obtain formula (8):

$$\left\{q_2^{64QAM} * b_0 + q_1^{64QAM} * b_1 + q_0^{64QAM} * a_0, q_2^{64QAM} * b_2 + q_1^{64QAM} * b_3 + q_0^{64QAM} * a_1\right\}$$
$$= \left\{k_{b1} q_1^{16QAM} * b_0 + k_{b0} q_0^{16QAM} * b_1, k_{b1} q_1^{16QAM} * b_2 + k_{b0} q_0^{16QAM} * b_3\right\} + k_a \left\{q_0^{QPSK} * a_0, q_0^{QPSK} * a_1\right\} \quad (8)$$

Likewise, the constellation pattern is a centro symmetric constellation diagram, and a real part and an imaginary part of a corresponding modulation symbol are the same. Therefore, to reduce calculation complexity, the first modification coefficient and the second modification coefficient can be obtained by using a numerical relationship between a real part of the combined modulation symbol and a real part of the joint modulation symbol.

The following formula (9) is obtained based on an equal relationship of real parts on two sides of an equal sign in formula (8):

$$\left\{q_2^{64QAM}*b_0+q_1^{64QAM}*b_1+q_0^{64QAM}*a_0\right\}=\left\{k_{b1}q_1^{16QAM}*b_0+k_{b0}q_0^{16QAM}*b_1,\quad k_{b1}q_1^{16QAM}*b_2+k_{b0}q_0^{16QAM}*b_3+k_aq_0^{QPSK}*a_0\right\}\quad (9)$$

Corresponding items on two sides of the equation are equal, and $x_0$, $x_1$ and $y_0$, $y_1$, $y_2$, $y_3$ represent a relationship of symbol items. Therefore, the first modification coefficient and the second modification coefficient can be obtained:

The first modification coefficient $k_a = q_0^{64QAM} \big/ q_0^{QPSK}$, and the second modification coefficient $k_{b0} = q_1^{64QAM} \big/ q_0^{16QAM}$.

For specific implementations of the first modulation scheme and the second modulation scheme given above, a corresponding first modulation coefficient and second modulation coefficient are shown in Table 1 below.

**Table 1**

| First modulation scheme | Second modulation scheme | Modification factor |
|---|---|---|
| QPSK | QPSK | $k_a = q_1^{16QAM} \big/ q_0^{QPSK}$ <br> $k_b = q_0^{16QAM} \big/ q_0^{QPSK}$ |
| QPSK | 16QAM | $k_a = q_0^{64QAM} \big/ q_0^{QPSK}$ <br> $k_{b0} = q_1^{64QAM} \big/ q_0^{16QAM}$ <br> $k_{b1} = q_2^{64QAM} \big/ q_1^{16QAM}$ |
| 16QAM | QPSK | $k_{a0} = q_0^{64QAM} \big/ q_0^{16QAM}$ <br> $k_{a1} = q_1^{64QAM} \big/ q_1^{16QAM}$ <br> $k_b = q_1^{64QAM} \big/ q_0^{QPSK}$ |

In this embodiment of the present application, certainly, the first modification coefficient and the second modification coefficient may also be obtained through calculation by using a numerical relationship between an imaginary part of the combined modulation symbol and an imaginary part of the joint modulation symbol. The foregoing two implementations may be selected based on an actual requirement. This is not limited in this embodiment of the present application.

In a specific implementation process, to ensure performance of each user equipment and a service requirement, a constellation diagram corresponding to the third modulation scheme is required to be a Gray code constellation diagram. As shown in FIG. 5, a quantity of different bits between bits of symbols corresponding to any two adjacent constellation points in a constellation diagram in FIG. 5 is 1.

Still referring to FIG. 5, because a channel condition is not optimal, when a modulation symbol modulated by using a QPSK modulation scheme reaches a receive end by using a channel and is demodulated, obtained data is not exactly located at an exact center position of one of four constellation points in a constellation diagram, but is distributed within a specific range around the four constellation points. If an example in which a bit stream is 11 is used, in a process of judging received data by the receive end, namely, the user equipment, a misjudgment may occur. A probability of misjudging 11 as 10 or 01 is greater than that of 00, in other words, a probability that an error bit quantity is 2 bits is less than a probability that an error bit quantity is 1 bit. Therefore, when the modulation constellation diagram is the Gray code constellation diagram, a misjudgment probability can be reduced, to ensure quality of a received signal of the user equipment and further ensure performance of each user equipment and a service requirement.

In a specific implementation process, when the modulation constellation diagram corresponding to the third modulation scheme is the Gray code constellation diagram, the first bit stream and the second bit stream are Gray code binary, and an expansion formula of the modulation function $F_{16QAM}$ used to modulate the combined bit stream in formula (3) is for natural binary. Therefore, the base station needs to convert the combined bit stream from the Gray code binary to the natural binary, to meet a requirement of formula (3). A conversion formula for converting the Gray code binary to the natural binary, for example, $Gray2Int(x_1, x_0)=(x_1, x_1 \odot x_0)$.

Further, the conversion formula for converting the Gray code binary to the natural binary is applied to formula (1), to obtain formula (10):

$$P * F_{16QAM}\left[Gray2Int\left(a_0, \ a_0 \odot b_0\right), \ Gray2Int\left(a_1, \ a_1 \odot b_1\right)\right] = k_a * P * F_{QPSK}\left[a_0', \ a_1'\right] + k_b * P * F_{QPSK}\left[b_0', \ b_1'\right] \quad (10)$$

Further, formula (2) and formula (3) are applied to formula (10), to obtain formula (11):

$$\left\{q_1^{16QAM} * a_0 + q_0^{16QAM} * \left(a_0 \odot b_0\right), \ q_1^{16QAM} * a_1 + q_0^{16QAM} * \left(a_1 \odot b_1\right)\right\} = k_a \left\{q_0^{QPSK} * a_0', \ q_0^{QPSK} * a_1'\right\} + k_b \left\{q_0^{QPSK} * b_0', \ q_0^{QPSK} * b_1'\right\} \quad (11)$$

Therefore, it can be learned according to formula (11) that, if $k_a = q_1^{16QAM} \big/ q_0^{QPSK}$, $k_b = q_0^{16QAM} \big/ q_0^{QPSK}$, $a_0' = a_0$, and $b_0' = a_0 \odot b_0$, it can be ensured that two sides of the equation in formula (11) are correct. Therefore, when the modulation constellation diagram corresponding to the third modulation scheme is the Gray code constellation diagram, before separately modulating the first bit stream and the second bit stream, the base station needs to perform XNOR processing on the second bit stream.

In this embodiment of the present application, if the first bit $a_0$ of the first bit stream $\{a_0, a_1, ...\}$ is used as the first bit of the combined bit stream, an XNOR operation needs to be performed on the second bit stream by using the first bit stream; or if the first bit $b_0$ of the second bit stream $\{b_0, b_1, b_2, b_3, ...\}$ is used as the first bit of the combined bit stream, an XNOR operation needs to be performed on the first bit stream by using the second bit stream. To be specific, a sequence of combining the first bit stream and the second bit stream needs to be consistent with that of performing the XNOR operation on the first bit stream and the second bit stream. This may be selected according to an actual situation. This is not limited in this embodiment of the present application.

Step 403: The base station modifies the first modulation symbol by using the first modification coefficient, to obtain a first modified modulation symbol, and modifies the second modulation symbol by using the second modification coefficient, to obtain a second modified modulation symbol.

In this embodiment of the present application, after obtaining the first modification coefficient and the second modification coefficient, the base station modifies the first modulation symbol by using the first modification coefficient, to obtain the first modified modulation symbol, and modifies the second modulation symbol by using the second modification coefficient, to obtain the second modified modulation symbol.

Step 404: The base station performs power control processing on the first modified modulation symbol by using a first power control factor, to obtain a first modified modulation symbol obtained after the power control, and performs power control processing on the second modified modulation symbol by using a second power control factor, to obtain a second modified modulation symbol obtained after the power control.

In this embodiment of the present application, the base station performs power control processing on the first modified modulation symbol by using the first power control factor and performs power control processing on the second modified modulation symbol by using the second power control factor. In a specific implementation process, the base station multiplies the first modified modulation symbol by the first power control factor, and multiplies the second modified modulation symbol by the second power control factor, so as to allocate power to the first user equipment and the second user equipment.

In this embodiment of the present application, the first power control factor $P_1$ and the second power control factor $P_2$ may be determined by using a downlink power allocation method in the prior art, for example, improving a transmit power of a reference signal or using a related mechanism for implementing inter-cell interference suppression in combination with user scheduling, or by using another power allocation method. This is not limited in this embodiment of the present application.

Step 405: The base station combines the first modified modulation symbol obtained after the power control and the second modified modulation symbol obtained after the power control, and sends a combined modulation symbol obtained after the power control.

In this embodiment of the present application, the base station performs layer mapping on the first modified modulation symbol obtained after the power control and the second modified modulation symbol obtained after the power control. The layer mapping is to re-map a code word stream to a plurality of layers according to a specific rule, and layer mapping data is mapped to an antenna port by multiplying a precoding matrix and then is sent out.

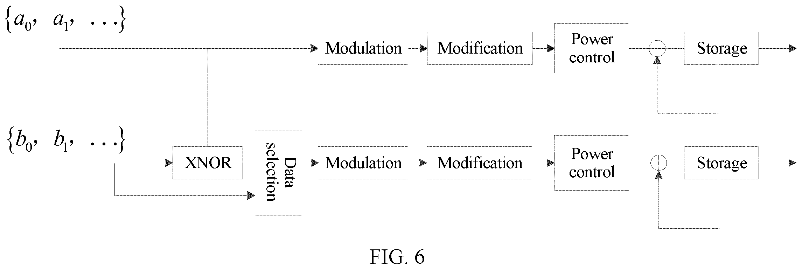

In this embodiment of the present application, when a modulation constellation diagram corresponding to a modulation scheme used to modulate the combined bit stream is a Gray code constellation diagram, a power control process is described. For details, refer to FIG. 6.

A first bit stream is denoted as $\{a_0, a_1, \cdots\}$, a second bit stream is denoted as $\{b_0, b_1, ...\}$, and a base station modulates the first bit stream $\{a_0, a_1, ...\}$ to obtain a first modulation symbol, and performs power control after modifying the first modulation symbol. Before modulating the second bit stream $\{b_0, b_1, ...\}$, the base station performs an XNOR operation by using the first bit stream $\{a_0, a_1, ...\}$ and the second bit stream $\{b_0, b_1, ...\}$, to obtain a third bit stream, modulates the third bit stream, obtains a second modulation symbol, performs power control after modifying the first modulation symbol and the second modulation symbol, combines modulation symbols obtained after the power control, and then sends a combined modulation symbol obtained after the power control.

In a specific implementation process, to adapt to a case in which a modulation constellation diagram corresponding to a modulation scheme used to modulate a combined bit stream is Gray code and a case in which the modulation constellation diagram is non-Gray code, the base station needs to select data before modulating the second bit stream. To be specific, when a modulation constellation diagram corresponding to a third modulation scheme is a Gray code constellation diagram, the base station needs to select a bit stream obtained by performing the XNOR operation on the first bit stream and the second bit stream. When a modulation constellation diagram corresponding to a third modulation scheme is a non-Gray code constellation diagram, the base station selects the second bit stream on which the XNOR operation is not performed. This selection process is added, so that the technical solutions in the embodiments of the present application are more universally applicable.

In this embodiment of the present application, a procedure of processing the first bit stream and the second bit stream by the base station may be performed in a parallel manner, or may be performed in a serial manner. When processing is performed in a serial manner, complexity is reduced. A specific processing manner is not limited in this embodiment of the present application.

In this embodiment of the present application, the base station separately modulates the first bit stream and the second bit stream, separately modifies the obtained first modulation symbol and the second modulation symbol, performs power control processing on a first modified modulation symbol by using a first power control factor, and performs power control processing on the second modified modulation symbol by using a second power control factor. To be specific, the base station separately allocates power to first user equipment and second user equipment, so that the base station combines a first modified modulation symbol obtained after the power control and a second modified modulation symbol obtained after the power control, and sends a combined modulation symbol obtained after the power control, to ensure that independent power allocation is performed on different user equipments while code division multiplexing is implemented, thereby improving flexibility of the power control and improving signal quality of user equipment.

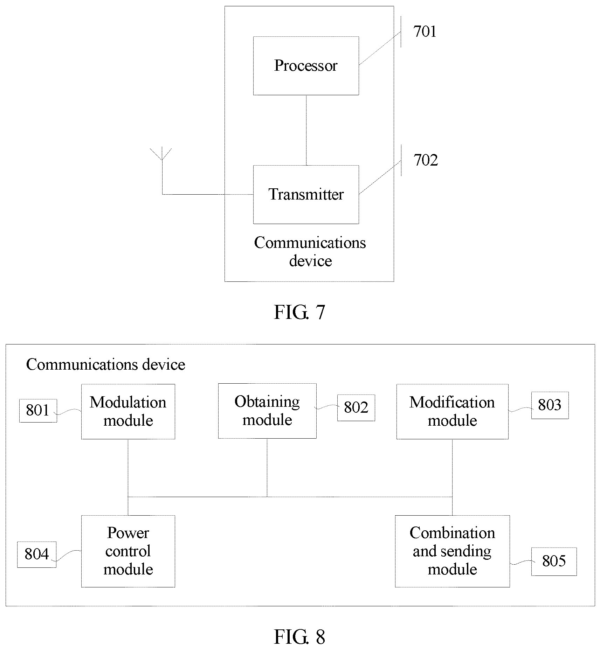

Referring to FIG. 7, an embodiment of the present application provides a communications device. The communications device includes a processor 701 and a transmitter 702. The transmitter 702 is coupled to the processor 701.

The processor 701 may be a central processing unit (CPU) or an application-specific integrated circuit (ASIC), may be one or more integrated circuits configured to control program execution, may be a baseband chip, or the like.

The communications device may further include a memory. The memory is coupled to the processor 701. There may be one or more memories. The memory may be a read-only memory (ROM), a random access memory (RAM), a magnetic disk memory, or the like.

Code corresponding to the foregoing power control method is written permanently into a chip through designing programming for the processor 701. In this way, when the code runs, the chip can perform the power control method provided the embodiment shown in FIG. 4. How to perform designing programming for the processor 701 is a well-known technology to persons skilled in the art. Details are not described herein.

Referring to FIG. 8, an embodiment of the present application provides a communications device. The communications device includes a modulation module 801, an obtaining module 802, a modification module 803, a power control module 804, and a combination and sending module 805.

In actual application, entity apparatuses corresponding to the modulation module 801, the obtaining module 802, the modification module 803, and the power control module 804 may be integrated into the processor 701 in FIG. 7, and an entity apparatus corresponding to the combination and sending module 805 may be integrated into the transmitter 702 in FIG. 7.

An embodiment of the present application provides a chip. The chip is configured to support a communications device in performing a corresponding function in the power control method provided in the embodiment shown in FIG. 4.

An embodiment of the present application provides a communications system, including a terminal device and a communications device provided in the embodiment shown in FIG. 7.

The communications device in this embodiment of the present application may be configured to perform the method provided in the embodiment shown in FIG. 4. For functions implemented by modules in the communications device, and the like, refer to descriptions of the method part. Details are not described herein again.

All or some of the foregoing embodiments in the present application may be implemented by using software, hardware, firmware, or any combination thereof. When software is used to implement the embodiments, the embodiments may be implemented completely or partially in a form of a computer program product. The computer program product includes one or more computer instructions. When the computer program instructions are loaded and executed on the computer, the procedures or functions according to the embodiments of the present application are all or partially generated. The computer may be a general-purpose computer, a dedicated computer, a computer network, or another programmable apparatus. The computer instructions may be stored in a computer-readable storage medium or may be transmitted from a computer-readable storage medium to another readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, microwave, or the like) manner. The computer-readable storage medium may be any usable medium accessible by a computer, or a data storage device integrating one or more usable media, for example, a server or a data center. The usable medium may be a magnetic medium (for example, a floppy disk, a hard disk, or a magnetic tape), an optical medium (for example, a DVD), a semiconductor medium (for example, a solid state disk (SSD)), or the like.

## Claims

1. A power control method, applied to a code division multiplexing communications system, and comprising:

   modulating (401), by a base station, a first bit stream by using a first modulation scheme, to obtain a first modulation symbol, modulating (401) a second bit stream by using a second modulation scheme, to obtain a second modulation symbol, and modulating (401), by using a third modulation scheme, a combined bit stream obtained by combining the first bit stream and the second bit stream, to obtain a joint modulation symbol, wherein the third modulation scheme is obtained based on the first modulation scheme and the second modulation scheme;

   obtaining (402), by the base station, a first modification coefficient and a second modification coefficient based on the first modulation symbol, the second modulation symbol, and the joint modulation symbol;

   modifying (403), by the base station, the first modulation symbol by using the first modification coefficient, to obtain a first modified modulation symbol, and modifying (403) the second modulation symbol by using the second modification coefficient, to obtain a second modified modulation symbol;

   performing (404), by the base station, power control processing on the first modified modulation symbol by using a preset first power control factor, to obtain a first modified modulation symbol obtained after the power control, and performing (404) power control processing on the second modified modulation symbol by using a preset second power control factor, to obtain a second modified modulation symbol obtained after the power control; and

   combining (405), by the base station, the first modified modulation symbol obtained after the power control and the second modified modulation symbol obtained after the power control, and sending (405) , to a terminal device, a combined modulation symbol obtained after the power control.

2. The method according to claim 1, wherein the obtaining, by the base station, a first modification coefficient and a second modification coefficient based on the first modulation symbol, the second modulation symbol, and the joint modulation symbol comprises:
   obtaining, by the base station, the first modification coefficient and the second modification coefficient based on an equivalent relationship between the joint modulation symbol and a combined modulation symbol that is obtained by combining a result obtained by multiplying the first modulation symbol by the first modification coefficient and a result obtained by multiplying the second modulation symbol by the second modification coefficient.

3. The method according to claim 2, wherein the obtaining, by the base station, the first modification coefficient and the second modification coefficient based on an equivalent relationship between the joint modulation symbol and the combined modulation symbol comprises:

   obtaining, by the base station, a real part of the combined modulation symbol and a real part of the joint modulation symbol; and

obtaining, by the base station, the first modification coefficient and the second modification coefficient based on a numerical relationship between the real part of the combined modulation symbol and the real part of the joint modulation symbol; or

the obtaining, by the base station, the first modification coefficient and the second modification coefficient based on an equivalent relationship between the joint modulation symbol and the combined modulation symbol comprises:

> obtaining, by the base station, an imaginary part of the combined modulation symbol and an imaginary part of the joint modulation symbol; and
>
> obtaining, by the base station, the first modification coefficient and the second modification coefficient based on a numerical relationship between the imaginary part of the combined modulation symbol and the imaginary part of the joint modulation symbol.

4. The method according to claim 1, wherein a modulation constellation diagram corresponding to the third modulation scheme is a Gray code modulation constellation diagram;

> before the modulating, by the base station, a second bit stream by using a second modulation scheme, to obtain a second modulation symbol, the method further comprises:
>
> > performing, by the base station, an XNOR operation on the first bit stream and the second bit stream, to obtain a third bit stream; and
> >
> > the modulating, by the base station, a second bit stream by using a second modulation scheme, to obtain a second modulation symbol comprises:
>
> modulating, by the base station, the third bit stream by using the second modulation scheme, to obtain the second modulation symbol.

5. The method according to any one of claims 1 to 4, wherein the performing, by the base station, power control processing on the first modified modulation symbol by using a preset first power control factor, to obtain a first modified modulation symbol obtained after the power control, and performing power control processing on the second modified modulation symbol by using a preset second power control factor, to obtain a second modified modulation symbol obtained after the power control comprises:

multiplying, by the base station, the first modified modulation symbol by the first power control factor, to obtain the first modified modulation symbol obtained after the power control, and multiplying the second modified modulation symbol by the second power control factor, to obtain the second modified modulation symbol obtained after the power control.

6. The method according to claim 5, wherein

> the first modulation scheme is a quadrature phase shift keying, QPSK, modulation scheme, and the second modulation scheme is a 16QAM modulation scheme or a QPSK modulation scheme; or
>
> the first modulation scheme is a 16QAM modulation scheme, and the second modulation scheme is a QPSK modulation scheme.

7. A communications device, applied to a code division multiplesxing communications system, and comprising:

> a processor (701), configured to: modulate a first bit stream by using a first modulation scheme, to obtain a first modulation symbol, modulate a second bit stream by using a second modulation scheme, to obtain a second modulation symbol, and modulate, by using a third modulation scheme, a combined bit stream obtained by combining the first bit stream and the second bit stream, to obtain a joint modulation symbol, wherein the third modulation scheme is obtained based on the first modulation scheme and the second modulation scheme; obtain a first modification coefficient and a second modification coefficient based on the first modulation symbol, the second modulation symbol, and the joint modulation symbol; modify the first modulation symbol by using the first modification coefficient, to obtain a first modified modulation symbol, and modify the second modulation symbol by using the second modification coefficient, to obtain a second modified modulation symbol; perform power control processing on the first modified modulation symbol by using a preset first power control factor, to obtain a first modified modulation symbol obtained after the power control, and perform power control processing on the second modified modulation symbol by using a preset second power control factor, to obtain a second modified modulation symbol obtained after the power control; and combine the first modified modulation symbol obtained after the power control and the second modified modulation symbol obtained after the power control, to obtain a combined modulation symbol obtained after power control; and

a transmitter (702), coupled to the processor, configured to send the combined modulation symbol obtained after the power control to a terminal device.

8. The communications device according to claim 7, wherein when obtaining the first modification coefficient and the second modification coefficient based on the first modulation symbol, the second modulation symbol, and the joint modulation symbol, the processor is specifically configured to:
obtain the first modification coefficient and the second modification coefficient based on an equivalent relationship between the joint modulation symbol and a combined modulation symbol that is obtained by combining a result obtained by multiplying the first modulation symbol by the first modification coefficient and a result obtained by multiplying the second modulation symbol by the second modification coefficient.

9. The communications device according to claim 8, wherein when obtaining the first modification coefficient and the second modification coefficient, the processor is specifically configured to:

obtain a real part of the combined modulation symbol and a real part of the joint modulation symbol; and
obtain the first modification coefficient and the second modification coefficient based on a numerical relationship between the real part of the combined modulation symbol and the real part of the joint modulation symbol; or when obtaining the first modification coefficient and the second modification coefficient, the processor is specifically configured to:

obtain an imaginary part of the combined modulation symbol and an imaginary part of the joint modulation symbol; and
obtain the first modification coefficient and the second modification coefficient based on a numerical relationship between the imaginary part of the combined modulation symbol and the imaginary part of the joint modulation symbol.

10. The communications device according to claim 9, wherein a modulation constellation diagram corresponding to the third modulation scheme is a Gray code modulation constellation diagram; and
the processor is further configured to:

before modulating the second bit stream by using the second modulation scheme, to obtain the second modulation symbol, perform an XNOR operation on the first bit stream and the second bit stream, to obtain a third bit stream; and
modulate the third bit stream by using the second modulation scheme, to obtain the second modulation symbol.

11. The communications device according to any one of claims 7 to 10, wherein when obtaining the first modified modulation symbol obtained after the power control and the second modified modulation symbol obtained after the power control, the processor is specifically configured to:
multiply the first modified modulation symbol by the first power control factor, to obtain the first modified modulation symbol obtained after the power control, and multiply the second modified modulation symbol by the second power control factor, to obtain the second modified modulation symbol obtained after the power control.

12. The communications device according to claim 11, wherein the first modulation scheme is a quadrature phase shift keying, QPSK, modulation scheme, and the second modulation scheme is a 16QAM modulation scheme or a QPSK modulation scheme; or
the first modulation scheme is a 16QAM modulation scheme, and the second modulation scheme is a QPSK modulation scheme.

13. A computer program product, wherein the computer program product comprises an instruction, and when the instruction runs on a computer, the computer performs the method according to any one of claims 1 to 6.

**Patentansprüche**

1. Leistungssteuerverfahren, das auf ein Codemultiplexkommunikationssystem angewandt wird und Folgendes umfasst:

   Modulieren (401) eines ersten Bitstroms durch eine Basisstation unter Verwendung eines ersten Modulationsschemas, um ein erstes Modulationssymbol zu erhalten, Modulieren (401) eines zweiten Bitstroms unter Verwendung eines zweiten Modulationsschemas, um ein zweites Modulationssymbol zu erhalten, und Modulieren (401) eines kombinierten Bitstroms, der durch Kombinieren des ersten Bitstroms und des zweiten Bitstroms erhalten wird, unter Verwendung eines dritten Modulationsschemas, um ein verbundenes Modulationssymbol zu erhalten, wobei das dritte Modulationsschema auf Basis des ersten Modulationsschemas und des zweiten Modulationsschemas erhalten wird;
   Erhalten (402) eines ersten Modifikationskoeffizienten und eines zweiten Modifikationskoeffizienten durch die Basisstation auf Basis des ersten Modulationssymbols, des zweiten Modulationssymbols und des verbundenen Modulationssymbols;
   Modifizieren (403) des ersten Modulationssymbols durch die Basisstation unter Verwendung des ersten Modifikationskoeffizienten, um ein erstes modifiziertes Modulationssymbol zu erhalten, und Modifizieren (403) des zweiten Modulationssymbols unter Verwendung des zweiten Modifikationskoeffizienten, um ein zweites modifiziertes Modulationssymbol zu erhalten;
   Durchführen (404) einer Leistungssteuerverarbeitung durch die Basisstation am ersten modifizierten Modulationssymbol unter Verwendung eines voreingestellten ersten Leistungssteuerfaktors, um ein erstes modifiziertes Modulationssymbol zu erhalten, das nach der Leistungssteuerung erhalten wird, und Durchführen (404) einer Leistungssteuerverarbeitung am zweiten modifizierten Modulationssymbol unter Verwendung eines voreingestellten zweiten Leistungssteuerfaktors, um ein zweites modifiziertes Modulationssymbol zu erhalten, das nach der Leistungssteuerung erhalten wird; und
   Kombinieren (405) des ersten modifizierten Modulationssymbols, das nach der Leistungssteuerung erhalten wird, und des zweiten modifizierten Modulationssymbols, das nach der Leistungssteuerung erhalten wird, durch die Basisstation und Senden (405) eines kombinierten Modulationssymbols, das nach der Leistungssteuerung erhalten wird, an eine Endgerätevorrichtung.

2. Verfahren nach Anspruch 1, wobei das Erhalten eines ersten Modifikationskoeffizienten und eines zweiten Modifikationskoeffizienten durch die Basisstation auf Basis des ersten Modulationssymbols, des zweiten Modulationssymbols und des verbundenen Modulationssymbols Folgendes umfasst:
   Erhalten des ersten Modifikationskoeffizienten und des zweiten Modifikationskoeffizienten durch die Basisstation auf Basis einer äquivalenten Beziehung zwischen dem verbundenen Modulationssymbol und einem kombinierten Modulationssymbol, das durch Kombinieren eines Ergebnisses, das durch Multiplizieren des ersten Modulationssymbols mit dem ersten Modifikationskoeffizienten erhalten wird, und eines Ergebnisses, das durch Multiplizieren des zweiten Modulationssymbols mit dem zweiten Modifikationskoeffizienten erhalten wird, erhalten wird.

3. Verfahren nach Anspruch 2, wobei das Erhalten des ersten Modifikationskoeffizienten und des zweiten Modifikationskoeffizienten durch die Basisstation auf Basis einer äquivalenten Beziehung zwischen dem verbundenen Modulationssymbol und dem kombinierten Modulationssymbol Folgendes umfasst:

   Erhalten eines realen Teils des kombinierten Modulationssymbols und eines realen Teils des verbundenen Modulationssymbols durch die Basisstation und
   Erhalten des ersten Modifikationskoeffizienten und des zweiten Modifikationskoeffizienten durch die Basisstation auf Basis einer numerischen Beziehung zwischen dem realen Teil des kombinierten Modulationssymbols und dem realen Teil des verbundenen Modulationssymbols; oder
   das Erhalten des ersten Modifikationskoeffizienten und des zweiten Modifikationskoeffizienten durch die Basisstation auf Basis einer äquivalenten Beziehung zwischen dem verbundenen Modulationssymbol und dem kombinierten Modulationssymbol Folgendes umfasst:

   Erhalten eines imaginären Teils des kombinierten Modulationssymbols und eines imaginären Teils des verbundenen Modulationssymbols durch die Basisstation und
   Erhalten des ersten Modifikationskoeffizienten und des zweiten Modifikationskoeffizienten durch die Basisstation auf Basis einer numerischen Beziehung zwischen dem imaginären Teil des kombinierten Modulationssymbols und dem imaginären Teil des verbundenen Modulationssymbols.

**4.** Verfahren nach Anspruch 1, wobei ein Modulationskonstellationsdiagramm, das dem dritten Modulationsschema entspricht, ein Gray-Code-Modulationskonstellationsdiagramm ist;
vor dem Modulieren eines zweiten Bitstroms durch die Basisstation unter Verwendung eines zweiten Modulationsschemas, um ein zweites Modulationssymbol zu erhalten, das Verfahren ferner Folgendes umfasst:

Durchführen einer XNOR-Operation durch die Basisstation am ersten Bitstrom und am zweiten Bitstrom, um einen dritten Bitstrom zu erhalten; und
das Modulieren eines zweiten Bitstroms durch die Basisstation unter Verwendung eines zweiten Modulationsschemas, um ein zweites Modulationssymbol zu erhalten, Folgendes umfasst:
Modulieren des dritten Bitstroms durch die Basisstation unter Verwendung des zweiten Modulationsschemas, um das zweite Modulationssymbol zu erhalten.

**5.** Verfahren nach einem der Ansprüche 1 bis 4, wobei das Durchführen einer Leistungssteuerverarbeitung durch die Basisstation am ersten modifizierten Modulationssymbol unter Verwendung eines voreingestellten ersten Leistungssteuerfaktors, um ein erstes modifiziertes Modulationssymbol zu erhalten, das nach der Leistungssteuerung erhalten wird, und das Durchführen einer Leistungssteuerverarbeitung am zweiten modifizierten Modulationssymbol unter Verwendung eines voreingestellten zweiten Leistungssteuerfaktors, um ein zweites modifiziertes Modulationssymbol zu erhalten, das nach der Leistungssteuerung erhalten wird, Folgendes umfasst:
Multiplizieren des ersten modifizierten Modulationssymbols durch die Basisstation mit dem ersten Leistungssteuerfaktor, um das erste modifizierte Modulationssymbol zu erhalten, das nach der Leistungssteuerung erhalten wird, und Multiplizieren des zweiten modifizierten Modulationssymbols mit dem zweiten Leistungssteuerfaktor, um das zweite modifizierte Modulationssymbol zu erhalten, das nach der Leistungssteuerung erhalten wird.

**6.** Verfahren nach Anspruch 5, wobei

das erste Modulationsschema ein Quadraturphasenumtastungs(QPSK)-Modulationsschema ist und das zweite Modulationsschema ein 16QAM-Modulationsschema oder ein QPSK-Modulationsschema ist oder
das erste Modulationsschema ein 16QAM-Modulationsschema ist und das zweite Modulationsschema ein QPSK-Modulationsschema ist.

**7.** Kommunikationsvorrichtung, die auf ein Codemultiplexkommunikationssystem angewandt wird und Folgendes umfasst:

einen Prozessor (701), der zu Folgendem ausgelegt ist: Modulieren eines ersten Bitstroms unter Verwendung eines ersten Modulationsschemas, um ein erstes Modulationssymbol zu erhalten, Modulieren eines zweiten Bitstroms unter Verwendung eines zweiten Modulationsschemas, um ein zweites Modulationssymbol zu erhalten, und Modulieren eines kombinierten Bitstroms, der durch Kombinieren des ersten Bitstroms und des zweiten Bitstroms erhalten wird, unter Verwendung eines dritten Modulationsschemas, um ein verbundenes Modulationssymbol zu erhalten, wobei das dritte Modulationsschema auf Basis des ersten Modulationsschemas und des zweiten Modulationsschemas erhalten wird; Erhalten eines ersten Modifikationskoeffizienten und eines zweiten Modifikationskoeffizienten auf Basis des ersten Modulationssymbols, des zweiten Modulationssymbols und des verbundenen Modulationssymbols; Modifizieren des ersten Modulationssymbols unter Verwendung des ersten Modifikationskoeffizienten, um ein erstes modifiziertes Modulationssymbol zu erhalten, und Modifizieren des zweiten Modulationssymbols unter Verwendung des zweiten Modifikationskoeffizienten, um ein zweites modifiziertes Modulationssymbol zu erhalten; Durchführen einer Leistungssteuerverarbeitung am ersten modifizierten Modulationssymbol unter Verwendung eines voreingestellten ersten Leistungssteuerfaktors, um ein erstes modifiziertes Modulationssymbol zu erhalten, das nach der Leistungssteuerung erhalten wird, und Durchführen einer Leistungssteuerverarbeitung am zweiten modifizierten Modulationssymbol unter Verwendung eines voreingestellten zweiten Leistungssteuerfaktors, um ein zweites modifiziertes Modulationssymbol zu erhalten, das nach der Leistungssteuerung erhalten wird; und Kombinieren des ersten modifizierten Modulationssymbols, das nach der Leistungssteuerung erhalten wird, und des zweiten modifizierten Modulationssymbols, das nach der Leistungssteuerung erhalten wird, um ein kombiniertes Modulationssymbol zu erhalten, das nach der Leistungssteuerung erhalten wird; und
einen Sender (702), der an den Prozessor gekoppelt und dazu ausgelegt ist, das kombinierte Modulationssymbol, das nach der Leistungssteuerung erhalten wird, an eine Endgerätevorrichtung zu senden.

**8.** Kommunikationsvorrichtung nach Anspruch 7, wobei der Prozessor, wenn er den ersten Modifikationskoeffizienten und den zweiten Modifikationskoeffizienten auf Basis des ersten Modulationssymbols, des zweiten Modulationssymbols und des verbundenen Modulationssymbols erhält, speziell zu Folgendem ausgelegt ist:
Erhalten des ersten Modifikationskoeffizienten und des zweiten Modifikationskoeffizienten auf Basis einer äquivalenten Beziehung zwischen dem verbundenen Modulationssymbol und einem kombinierten Modulationssymbol, das durch Kombinieren eines Ergebnisses, das durch Multiplizieren des ersten Modulationssymbols mit dem ersten Modifikationskoeffizienten erhalten wird, und eines Ergebnisses, das durch Multiplizieren des zweiten Modulationssymbols mit dem zweiten Modifikationskoeffizienten erhalten wird, erhalten wird.

9. Kommunikationsvorrichtung nach Anspruch 8, wobei der Prozessor, wenn er den ersten Modifikationskoeffizienten und den zweiten Modifikationskoeffizienten erhält, speziell zu Folgendem ausgelegt ist:

Erhalten eines realen Teils des kombinierten Modulationssymbols und eines realen Teils des verbundenen Modulationssymbols und
Erhalten des ersten Modifikationskoeffizienten und des zweiten Modifikationskoeffizienten auf Basis einer numerischen Beziehung zwischen dem realen Teil des kombinierten Modulationssymbols und dem realen Teil des verbundenen Modulationssymbols; oder,
wenn der Prozessor den ersten Modifikationskoeffizienten und den zweiten Modifikationskoeffizienten erhält, er speziell zu Folgendem ausgelegt ist:

Erhalten eines imaginären Teils des kombinierten Modulationssymbols und eines imaginären Teils des verbundenen Modulationssymbols und
Erhalten des ersten Modifikationskoeffizienten und des zweiten Modifikationskoeffizienten auf Basis einer numerischen Beziehung zwischen dem imaginären Teil des kombinierten Modulationssymbols und dem imaginären Teil des verbundenen Modulationssymbols.

10. Kommunikationsvorrichtung nach Anspruch 9, wobei ein Modulationskonstellationsdiagramm, das dem dritten Modulationsschema entspricht, ein Gray-Code-Modulationskonstellationsdiagramm ist; und
der Prozessor ferner zu Folgendem ausgelegt ist:

vor dem Modulieren des zweiten Bitstroms unter Verwendung des zweiten Modulationsschemas, um das zweite Modulationssymbol zu erhalten, Durchführen einer XNOR-Operation am ersten Bitstrom und am zweiten Bitstrom, um einen dritten Bitstrom zu erhalten; und
Modulieren des dritten Bitstroms unter Verwendung des zweiten Modulationsschemas, um das zweite Modulationssymbol zu erhalten.

11. Kommunikationsvorrichtung nach einem der Ansprüche 7 bis 10, wobei der Prozessor, wenn er das erste modifizierte Modulationssymbol, das nach der Leistungssteuerung erhalten wird, und das zweite modifizierte Modulationssymbol, das nach der Leistungssteuerung erhalten wird, erhält, speziell zu Folgendem ausgelegt ist:
Multiplizieren des ersten modifizierten Modulationssymbols mit dem ersten Leistungssteuerfaktor, um das erste modifizierte Modulationssymbol zu erhalten, das nach der Leistungssteuerung erhalten wird, und Multiplizieren des zweiten modifizierten Modulationssymbols durch den zweiten Leistungssteuerfaktor, um das zweite modifizierte Modulationssymbol zu erhalten, das nach der Leistungssteuerung erhalten wird.

12. Kommunikationsvorrichtung nach Anspruch 11, wobei das erste Modulationsschema ein Quadraturphasenumtastungs(QPSK)-Modulationsschema ist und das zweite Modulationsschema ein 16QAM-Modulationsschema oder ein QPSK-Modulationsschema ist oder
das erste Modulationsschema ein 16QAM-Modulationsschema ist und das zweite Modulationsschema ein QPSK-Modulationsschema ist.

13. Computerprogrammprodukt, wobei das Computerprogrammprodukt eine Anweisung umfasst und wenn die Anweisung auf einem Computer ausgeführt wird, der Computer das Verfahren nach einem der Ansprüche 1 bis 6 durchführt.

**Revendications**

1. Procédé de commande de puissance, appliqué sur un système de communication à multiplexage par répartition en code, et comprenant :

la modulation (401), par une station de base, d'un premier train de bits en utilisant un premier schéma de modulation, pour obtenir un premier symbole de modulation, la modulation (401) d'un deuxième train de bits en utilisant un deuxième schéma de modulation, pour obtenir un second symbole de modulation, et la modulation (401), en utilisant un troisième schéma de modulation, d'un train combiné de bits obtenu en combinant le premier train de bits et le deuxième train de bits, pour obtenir un symbole de modulation conjoint, dans lequel le troisième schéma de modulation est obtenu sur la base du premier schéma de modulation et du deuxième schéma de modulation ;

l'obtention (402), par la station de base, d'un premier coefficient de modification et d'un second coefficient de modification sur la base du premier symbole de modulation, du second symbole de modulation, et du symbole de modulation conjoint ;

la modification (403), par la station de base, du premier symbole de modulation en utilisant le premier coefficient de modification, pour obtenir un premier symbole de modulation modifié, et la modification (403) du second symbole de modulation en utilisant le second coefficient de modification, pour obtenir un second symbole de modulation modifié ;

la réalisation (404), par la station de base, d'un traitement de commande de puissance sur le premier symbole de modulation modifié en utilisant un premier facteur de commande de puissance prédéfini, pour obtenir un premier symbole de modulation modifié obtenu après la commande de puissance, et la réalisation (404) d'un traitement de commande de puissance sur le second symbole de modulation modifié en utilisant un second facteur de commande de puissance prédéfini, pour obtenir un second symbole de modulation modifié obtenu après la commande de puissance ; et

la combinaison (405), par la station de base, du premier symbole de modulation modifié obtenu après la commande de puissance et du second symbole de modulation modifié obtenu après la commande de puissance, et l'envoi (405), à un dispositif de terminal, d'un symbole de modulation combiné obtenu après la commande de puissance.

2. Procédé selon la revendication 1, dans lequel l'obtention, par la station de base, d'un premier coefficient de modification et d'un second coefficient de modification sur la base du premier symbole de modulation, du second symbole de modulation, et du symbole de modulation conjoint comprend :

l'obtention, par la station de base, du premier coefficient de modification et du second coefficient de modification sur la base d'une relation équivalente entre le symbole de modulation conjoint et un symbole de modulation combiné qui est obtenu en combinant un résultat obtenu en multipliant le premier symbole de modulation par le premier coefficient de modification et un résultat obtenu en multipliant le second symbole de modulation par le second coefficient de modification.

3. Procédé selon la revendication 2, dans lequel l'obtention, par la station de base, du premier coefficient de modification et du second coefficient de modification sur la base d'une relation équivalente entre le symbole de modulation conjoint et le symbole de modulation combiné comprend :

l'obtention, par la station de base, d'une partie réelle du symbole de modulation combiné et d'une partie réelle du symbole de modulation conjoint ; et

l'obtention, par la station de base, du premier coefficient de modification et du second coefficient de modification sur la base d'une relation numérique entre la partie réelle du symbole de modulation combiné et la partie réelle du symbole de modulation conjoint ; ou

l'obtention, par la station de base, du premier coefficient de modification et du second coefficient de modification sur la base d'une relation équivalente entre le symbole de modulation conjoint et le symbole de modulation combiné comprend :

l'obtention, par la station de base, d'une partie imaginaire du symbole de modulation combiné et d'une partie imaginaire du symbole de modulation conjoint ; et

l'obtention, par la station de base, du premier coefficient de modification et du second coefficient de modification sur la base d'une relation numérique entre la partie imaginaire du symbole de modulation combiné et la partie imaginaire du symbole de modulation conjoint.

4. Procédé selon la revendication 1, dans lequel un diagramme de constellation de modulation correspondant au troisième schéma de modulation est un diagramme de constellation de modulation à code Gray ;

avant la modulation, par la station de base, d'un deuxième train de bits en utilisant un deuxième schéma de modulation, pour obtenir un second symbole de modulation, le procédé comprend en outre :

la réalisation, par la station de base, d'une opération XNOR sur le premier train de bits et le deuxième train de bits, pour obtenir un troisième train de bits ; et

la modulation, par la station de base, d'un deuxième train de bits en utilisant un deuxième schéma de modulation, pour obtenir un second symbole de modulation comprend :

la modulation, par la station de base, du troisième train de bits en utilisant le deuxième schéma de modulation, pour obtenir le second symbole de modulation.

5. Procédé selon l'une quelconque des revendications 1 à 4, la réalisation, par la station de base, d'un traitement de commande de puissance sur le premier symbole de modulation modifié en utilisant un premier facteur de commande de puissance prédéfini, pour obtenir un premier symbole de modulation modifié obtenu après la commande de puissance, et la réalisation d'un traitement de commande de puissance sur le second symbole de modulation modifié en utilisant un second facteur de commande de puissance prédéfini, pour obtenir un second symbole de modulation modifié obtenu après la commande de puissance comprenant :

la multiplication, par la station de base, du premier symbole de modulation modifié par le premier facteur de commande de puissance, pour obtenir le premier symbole de modulation modifié obtenu après la commande de puissance, et la multiplication du second symbole de modulation modifié par le second facteur de commande de puissance, pour obtenir le second symbole de modulation modifié obtenu après la commande de puissance.

6. Procédé selon la revendication 5, dans lequel

le premier schéma de modulation est un schéma de modulation à modulation par déplacement de phase en quadrature, QPSK, et le deuxième schéma de modulation est un schéma de modulation 16QAM ou un schéma de modulation QPSK ; ou

le premier schéma de modulation est un schéma de modulation 16QAM, et le deuxième schéma de modulation est un schéma de modulation QPSK.

7. Dispositif de communication, appliqué sur un système de communication à multiplexage par répartition en code, et comprenant :

un processeur (701), configuré pour : moduler un premier train de bits en utilisant un premier schéma de modulation, pour obtenir un premier symbole de modulation, moduler un deuxième train de bits en utilisant un deuxième schéma de modulation, pour obtenir un second symbole de modulation, et moduler, en utilisant un troisième schéma de modulation, un train combiné de bits obtenu en combinant le premier train de bits et le deuxième train de bits, pour obtenir un symbole de modulation conjoint, dans lequel le troisième schéma de modulation est obtenu sur la base du premier schéma de modulation et du deuxième schéma de modulation ; obtenir un premier coefficient de modification et un second coefficient de modification sur la base du premier symbole de modulation, du second symbole de modulation, et du symbole de modulation conjoint ; modifier le premier symbole de modulation en utilisant le premier coefficient de modification, pour obtenir un premier symbole de modulation modifié, et modifier le second symbole de modulation en utilisant le second coefficient de modification, pour obtenir un second symbole de modulation modifié ; réaliser un traitement de commande de puissance sur le premier symbole de modulation modifié en utilisant un premier facteur de commande de puissance prédéfini, pour obtenir un premier symbole de modulation modifié obtenu après la commande de puissance, et réaliser un traitement de commande de puissance sur le second symbole de modulation modifié en utilisant un second facteur de commande de puissance prédéfini, pour obtenir un second symbole de modulation modifié obtenu après la commande de puissance ; et combiner le premier symbole de modulation modifié obtenu après la commande de puissance et le second symbole de modulation modifié obtenu après la commande de puissance, pour obtenir un symbole de modulation combiné obtenu après la commande de puissance ; et

un transmetteur (702), couplé au processeur, configuré pour envoyer le symbole de modulation combiné obtenu après la commande de puissance à un dispositif de terminal.

8. Dispositif de communication selon la revendication 7, dans lequel, lors de l'obtention du premier coefficient de modification et du second coefficient de modification sur la base du premier symbole de modulation, du second symbole de modulation, et du symbole de modulation conjoint, le processeur est spécifiquement configuré pour :

obtenir le premier coefficient de modification et le second coefficient de modification sur la base d'une relation équivalente entre le symbole de modulation conjoint et un symbole de modulation combiné qui est obtenu en combinant un résultat obtenu en multipliant le premier symbole de modulation par le premier coefficient de modification et un résultat obtenu en multipliant le second symbole de modulation par le second coefficient de modification.

9. Dispositif de communication selon la revendication 8, dans lequel, lors de l'obtention du premier coefficient de modification et du second coefficient de modification, le processeur est spécifiquement configuré pour :

   obtenir une partie réelle du symbole de modulation combiné et une partie réelle du symbole de modulation conjoint ; et
   obtenir le premier coefficient de modification et le second coefficient de modification sur la base d'une relation numérique entre la partie réelle du symbole de modulation combiné et la partie réelle du symbole de modulation conjoint ; ou
   lors de l'obtention du premier coefficient de modification et du second coefficient de modification, le processeur est spécifiquement configuré pour :

   obtenir une partie imaginaire du symbole de modulation combiné et une partie imaginaire du symbole de modulation conjoint ; et
   obtenir le premier coefficient de modification et le second coefficient de modification sur la base d'une relation numérique entre la partie imaginaire du symbole de modulation combiné et la partie imaginaire du symbole de modulation conjoint.

10. Dispositif de communication selon la revendication 9, dans lequel un diagramme de constellation de modulation correspondant au troisième schéma de modulation est un diagramme de constellation de modulation à code Gray ; et le processeur est en outre configuré pour :

   avant la modulation du deuxième train de bits en utilisant le deuxième schéma de modulation, pour obtenir le second symbole de modulation, réaliser une opération XNOR sur le premier train de bits et le deuxième train de bits, pour obtenir un troisième train de bits ; et
   moduler le troisième train de bits en utilisant le deuxième schéma de modulation, pour obtenir le second symbole de modulation.

11. Dispositif de communication selon l'une quelconque des revendications 7 à 10, dans lequel, lors de l'obtention du premier symbole de modulation modifié obtenu après la commande de puissance et du second symbole de modulation modifié obtenu après la commande de puissance, le processeur est spécifiquement configuré pour :
    multiplier le premier symbole de modulation modifié par le premier facteur de commande de puissance, pour obtenir le premier symbole de modulation modifié obtenu après la commande de puissance, et multiplier le second symbole de modulation modifié par le second facteur de commande de puissance, pour obtenir le second symbole de modulation modifié obtenu après la commande de puissance.

12. Dispositif de communication selon la revendication 11, dans lequel le premier schéma de modulation est un schéma de modulation à modulation par déplacement de phase en quadrature, QPSK, et le deuxième schéma de modulation est un schéma de modulation 16QAM ou un schéma de modulation QPSK ; ou
    le premier schéma de modulation est un schéma de modulation 16QAM, et le deuxième schéma de modulation est un schéma de modulation QPSK.

13. Produit programme d'ordinateur, dans lequel le produit programme d'ordinateur comprend une instruction, et, lorsque l'instruction est exécutée sur un ordinateur, l'ordinateur réalise le procédé selon l'une quelconque des revendications 1 à 6.

Evolved packet system

FIG. 1

FIG. 2

FIG. 3

Modulate a first bit stream by using a first modulation scheme, to obtain a first modulation symbol, modulate a second bit stream by using a second modulation scheme, to obtain a second modulation symbol, and modulate, by using a third modulation scheme, a combined bit stream obtained by combining the first bit stream and the second bit stream, to obtain a joint modulation symbol — 401

Obtain a first modification coefficient and a second modification coefficient based on the first modulation symbol, the second modulation symbol, and the joint modulation symbol — 402

Modify the first modulation symbol by using the first modification coefficient, to obtain a first modified modulation symbol, and modify the second modulation symbol by using the second modification coefficient, to obtain a second modified modulation symbol — 403

Perform power control processing on the first modified modulation symbol by using a first power control factor, to obtain a first modified modulation symbol obtained after the power control, and perform power control processing on the second modified modulation symbol by using a second power control factor, to obtain a second modified modulation symbol obtained after the power control — 404

Combine the first modified modulation symbol obtained after the power control and the second modified modulation symbol obtained after the power control, and send a combined modulation symbol obtained after the power control — 405

FIG. 4

FIG. 5

$\{a_0, \quad a_1, \quad \ldots\}$

$\{b_0, \quad b_1, \quad \ldots\}$

| Modulation | Modification | Power control | Storage |

XNOR → Data selection → | Modulation | Modification | Power control | Storage |

FIG. 6

701

Processor

702

Transmitter

Communications
device

**FIG. 7**

Communications device

801 — Modulation module

802 — Obtaining module

803 — Modification module

804 — Power control module

805 — Combination and sending module

**FIG. 8**

**REFERENCES CITED IN THE DESCRIPTION**

**Patent documents cited in the description**

- WO 2016144100 A1